(19) Europäisches Patentamt
European Patent Office
Office européen des brevets

(11) **EP 3 621 109 B1**

(12) **EUROPEAN PATENT SPECIFICATION**

(45) Date of publication and mention
of the grant of the patent:
**11.05.2022 Bulletin 2022/19**

(21) Application number: **19193876.0**

(22) Date of filing: **27.08.2019**

(51) International Patent Classification (IPC):
*H01L 25/075* (2006.01)     *H01L 33/50* (2010.01)
*H01L 33/60* (2010.01)

(52) Cooperative Patent Classification (CPC):
**H01L 25/0753; H01L 33/505;** H01L 33/44;
H01L 33/507; H01L 33/508; H01L 33/60

(54) **DISPLAY DEVICE**

ANZEIGEVORRICHTUNG

DISPOSITIF D'AFFICHAGE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **07.09.2018 US 201862728118 P**
**25.02.2019 CN 201910137463**

(43) Date of publication of application:
**11.03.2020 Bulletin 2020/11**

(73) Proprietor: **InnoLux Corporation**
**Chu-Nan, Miao-Li 350 (TW)**

(72) Inventor: **KUO, Shu-Ming**
**350 Miao-Li County (TW)**

(74) Representative: **2K Patentanwälte Blasberg
Kewitz & Reichel
Partnerschaft mbB
Schumannstrasse 27
60325 Frankfurt am Main (DE)**

(56) References cited:
**EP-A1- 3 316 301        US-A1- 2015 255 505
US-A1- 2018 151 543      US-A1- 2018 182 931
US-A1- 2018 226 597      US-B1- 9 472 734**

**Description**

**BACKGROUND**

**Technical Field**

The present invention relates to a display device, and in particular relates to the configuration of the elements in the display device.

**Description of the Related Art**

Electronic products that come with a display panel, such as smartphones, tablets, notebooks, monitors, and TVs, have become indispensable necessities in modern society. With the flourishing development of such portable electronic products, consumers have high expectations regarding the quality, functionality, and price of such products.

In recent years, light-emitting diodes (LEDs) have been widely used. The light-emitting diodes have been thinned, miniaturized, and arrayed by the micro light-emitting diode (micro LED) technology. Although currently existing light-emitting diodes have been adequate for their intended purposes, they have not been entirely satisfactory in all respects. For example, the problems such as the improvement of light conversion efficiency or light extraction efficiency etc. still exist. Accordingly, the development of a structural design of the display device that is capable of further improving the performance of light-emitting diodes is still one of the goals that the industry currently aims for. US 2018/151543 A1 discloses a display device including a growth substrate; a plurality of semiconductor light emitting devices grown on the growth substrate and disposed on one surface of the growth substrate; a plurality of through holes passing through the growth substrate at positions overlapping with the semiconductor light emitting devices; a wavelength conversion material filled into the through holes to convert a wavelength of light emitted from corresponding semiconductor light emitting devices; and a wiring substrate electrically connected to an electrode of the semiconductor light emitting devices disposed at an opposite side of the growth substrate by interposing the semiconductor light emitting devices therebetween.

US 2015/255505 A1 discloses a display device including a wiring substrate having a first substrate layer and a second substrate layer, a conductive adhesive layer configured to cover the wiring substrate, a plurality of semiconductor light emitting devices coupled to the conductive adhesive layer and electrically connected to a first electrode and a second electrode. Further, the first electrode is disposed on the first substrate layer, and the second substrate layer has one surface facing the conductive adhesive layer and the other surface covering the first electrode, and an auxiliary electrode electrically connected to the first electrode and the second electrode are disposed on one surface of the second substrate layer. US 2018/182931 A1 discloses a light emitting device package including a light emitting structure including a first light emitting cell, a second light emitting cell, and a third light emitting cell, each of the first to third light emitting cells including an active layer to emit light of a first wavelength in a first direction and being separated from each other in a second direction, orthogonal to the first direction, a first light adjusting portion including a first wavelength conversion layer in a first recess portion of the first light emitting cell, the first wavelength conversion layer to convert light of the first wavelength to light of a second wavelength, and a second light adjusting portion including a second wavelength conversion layer in a second recess portion of the second light emitting cell, the second wavelength conversion layer to convert light of the first wavelength to light of a third wavelength.

**SUMMARY**

In accordance with the present invention, a display device according to claim 1 is provided. Specific embodiment of the present invention are defined by the dependent claims.

A detailed description is given in the following embodiments with reference to the accompanying drawings.

**BRIEF DESCRIPTION OF THE DRAWINGS**

The disclosure may be more fully understood by reading the subsequent detailed description and examples with references made to the accompanying drawings, wherein:

FIG. 1 illustrates a top-view diagram of the display device in accordance with some embodiments of the present 2. invention.

FIG. 2 illustrates a cross-sectional diagram of the subpixel along the line segment X-X' in FIG. 1 in accordance with some examples not forming part of the present invention.

FIGs. 3A and 3B illustrate the cross-sectional diagrams of the light-emitting unit in accordance with some embodiments of the present invention.

FIG. 4A illustrates a top-view diagram of the light-emitting unit and the light conversion layer in accordance with some examples not forming part of the present invention.

FIG. 4B illustrates a cross-sectional diagram along the line segment Y-Y' in FIG. 4A in accordance with some examples not forming part of the present invention.

FIGs. 5A-5E illustrate the top-view diagrams of the active layer of the light-emitting unit in accordance with some embodiments of the present invention.

FIG. 6A illustrates a top-view diagram of the light-emitting unit and the light conversion layer in accordance with some examples not forming part of the present invention.

FIG. 6B illustrates a cross-sectional diagram of the light-emitting unit and the light conversion layer along the line segment Y-Y' in FIG. 6A in accordance with some examples not forming part of the present invention.

FIG. 7A illustrates a top-view diagram of the light-emitting unit and the light conversion layer in accordance with some examples not forming part of the present invention.

FIG. 7B illustrates a cross-sectional diagram of the light-emitting unit and the light conversion layer along the line segment Y-Y' in FIG. 7A in accordance with some examples not forming part of the present invention.

FIG. 8 illustrates a cross-sectional diagram of the display device in accordance with some examples not forming part of the present invention.

FIG. 9 illustrates a cross-sectional diagram of the display device in accordance with some examples not forming part of the present invention.

FIG. 10 illustrates a cross-sectional diagram of the display device in accordance with some embodiments of the present invention.

## DETAILED DESCRIPTION

The structure of the display device of the present invention and the manufacturing method thereof are described in detail in the following description. In the following detailed description, for purposes of explanation, numerous specific details and embodiments are set forth in order to provide a thorough understanding of the present invention.
. The specific elements and configurations described in the following detailed description are set forth in order to clearly describe the present invention.
. It will be apparent, however, that the exemplary embodiments set forth herein are used merely for the purpose of illustration, and the inventive concept may be embodied in various forms without being limited to those exemplary embodiments. In addition, the drawings of different embodiments may use like and/or corresponding numerals to denote like and/or corresponding elements in order to clearly describe the present invention.
. However, the use of like and/or corresponding numerals in the drawings of different embodiments does not suggest any correlation between different embodiments. In addition, in this specification, expressions such as "first material layer disposed on/over a second material layer", may indicate the direct contact of the first material layer and the second material layer, or it may indicate a non-contact state with one or more intermediate layers between the first material layer and the second material layer. In the above situation, the first material layer may not be in direct contact with the second material layer.
It should be noted that the elements or devices in the drawings of the present invention may be present in any form or configuration known to those with ordinary skill in the art. In addition, in the embodiments, relative expressions are used. For example, "lower", "bottom", "higher" or "top" are used to describe the position of one element relative to another. It should be appreciated that if a device is flipped upside down, an element that is "lower" will become an element that is "higher".
It should be understood that, although the terms first, second, third etc. may be used herein to describe various elements, components, regions, layers, portions and/or sections, these elements, components, regions, layers, portions and/or sections should not be limited by these terms. These terms are only used to distinguish one element, component, region, layer, portion or section from another element, component, region, layer, position or section. Thus, a first element, component, region, layer, portion or section discussed below could be termed a second element, component, region, layer, portion or section without departing from the scope of the present invention as defined by the claims.

It should be understood that the descriptions of the exemplary embodiments are intended to be read in connection with the accompanying drawings, which are to be considered part of the entire written description. The drawings are not drawn to scale. In addition, structures and devices are shown schematically in order to simplify the drawing.

The terms "about" and "substantially" typically mean +/- 20% of the stated value, more typically +/- 10% of the stated value, more typically +/- 5% of the stated value, more typically +/- 3% of the stated value, more typically +/- 2% of the stated value, more typically +/- 1% of the stated value and even more typically +/- 0.5% of the stated value. The stated value of the present invention is an approximate value. When there is no specific description, the stated value includes the meaning of "about" or "substantially".

Unless defined otherwise, all technical and scientific terms used herein have the same meaning as commonly understood by one of ordinary skill in the art to which this disclosure belongs. It should be appreciated that, in each case, the term, which is defined in a commonly used dictionary, should be interpreted as having a meaning that conforms to the relative skills of the present disclosure and the background or the context of the present invention, and should not be interpreted in an idealized or overly formal manner unless so defined.

In addition, in some embodiments of the present invention, terms concerning attachments, coupling and the like, such as "connected" and "interconnected", refer to a relationship wherein structures are secured or attached to one another either directly or indirectly through intervening structures, as well as both movable or rigid attachments or relationships, unless expressly described otherwise.

Furthermore, the phrase "in a range between a first value and a second value" or "in a range from a first value to a second value" indicates that the range includes the first value, the second value, and other values between them.

In accordance with the present invention, a display device is provided. The display device includes a light-emitting unit and a light conversion layer that are configured in a specific manner so that light conversion efficiency or light-emitting efficiency of the display device may be improved.

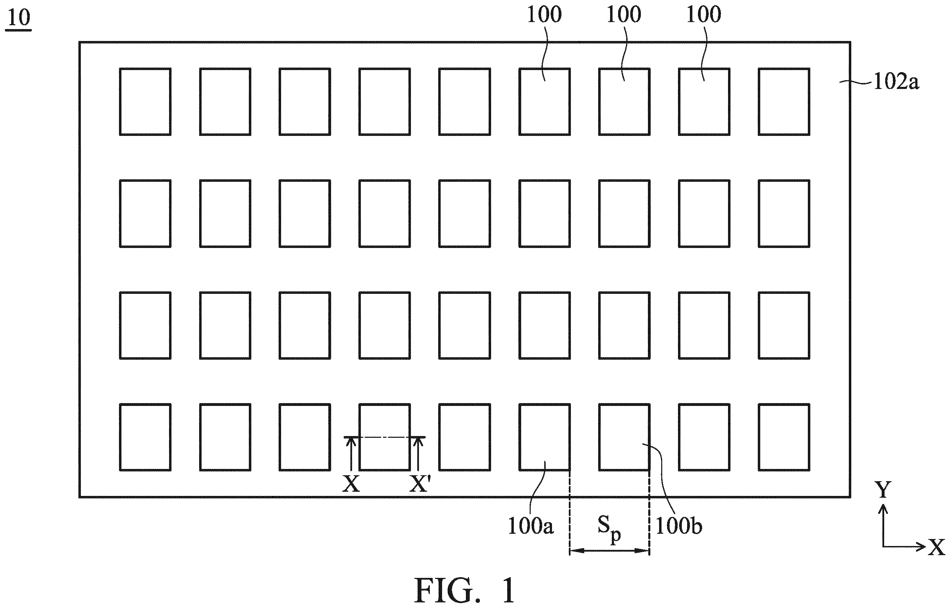

FIG. 1 illustrates a top-view diagram of a display device 10 in accordance with some embodiments of the present invention. . It should be understood that only some of the elements of the display device 10 are shown in FIG. 1 for clarity of illustration. In accordance with some embodiments of the present invention, additional features may be added to the display device 10 as described below. In some other embodiments, some of the features of the display device 10 described below may be replaced or omitted.

Referring to FIG. 1, the display device 10 may include a first substrate 102a and a plurality of subpixels 100 disposed on the first substrate 102a. For convenience of description, the two subpixels 100 are denoted as a first subpixel 100a and a second subpixel 100b herein, and the first subpixel 100a and the second subpixel 100b are taken as an example to illustrate the pitch of the subpixels 100. As shown in FIG. 1, the second subpixel 100b is disposed adjacent to the first subpixel 100a, and spaced apart from each other by a pitch $S_p$. In some embodiments, the display device 10 may be, for example, a flexible display device, a touch display device, a tiled display device, or a curved display device, but the present invention is not limited thereto.

It should be understood that the term "pitch" as used herein may be defined as the distance between the center point of a region of one subpixel and the center point of a region of another subpixel that is adjacent thereto. Alternatively, as shown in FIG. 1, the term "pitch" may be defined as the distance between an edge of one side (e.g., the right side) of a region of one subpixel (e.g., the first subpixel 100a) and an edge of the same side (e.g., the right side) of a region of another subpixel (e.g., the second subpixel 100b) that is adjacent thereto. Moreover, the first subpixel 100a and the second subpixel 100b may emit light of different or the same color. For example, the first subpixel 100a and the second subpixel 100b may emit red light, green light, blue light, or white light and so on, but the present invention is not limited thereto.

In some embodiments, the first substrate 102a may be an array substrate. For example, the first substrate 102a may serve as a driving substrate of the display device 10. Specifically, the first substrate 102a may include a driving circuit (not illustrated), and the driving circuit may include, for example, an active driving circuit or a passive driving circuit. In accordance with some embodiments, the driving circuit may include, but is not limited to, a transistor (e.g., a switching transistor or a driving transistor and so on), a data line, a scan line, a conductive pad, a dielectric layer, or other circuits and so on. The switching transistor may be used to control the lighting-on or turning-off of the subpixel 100. In some embodiments, the driving circuit may control the subpixel 100 by an external integrated circuit (IC) or microchip and so on.

In some embodiments, the material of the first substrate 102a may include, but is not limited to, glass, quartz, sapphire, polycarbonate (PC), polyimide (PI), polyethylene terephthalate (PET), rubbers, glass fibers, ceramics, another suitable material, or a combination thereof. In some embodiments, the first substrate 102a may include a metal-glass fiber composite plate, a metalceramic composite plate, or a printed circuit board and so on.

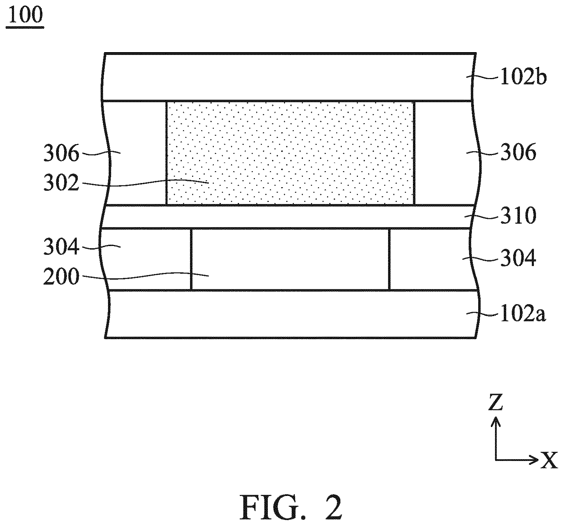

Next, refer to FIG. 2, which illustrates a cross-sectional diagram of the subpixel 100 along the line segment X-X' in FIG. 1 in accordance with some examples not forming part of the present invention. It should be understood that only some of the elements of the subpixel 100 are shown in FIG. 2 to illustrate the positional relationship between the elements.

As shown in FIG. 2, the subpixel 100 may include a second substrate 102b that is disposed opposite to the first substrate 102a in accordance with some embodiments. In some embodiments, the material of the second substrate 102b may include, but is not limited to, glass, quartz, sapphire, polycarbonate (PC), polyimide (PI), polyethylene terephthalate (PET), rubbers, glass fibers, ceramics, other suitable materials, or a combination thereof.

In some other embodiments, a protective layer may be used to replace the second substrate 102b. In some embodiments, the protective layer may include an organic material or an inorganic material. The protective layer may be formed by a coating process. In some embodiments, the organic material may include, but is not limited to, an epoxy resin, an acrylic resin such as polymethylmetacrylate (PMMA), benzocyclobutene (BCB), polyimide, polyester, polydimethylsiloxane (PDMS), other suitable materials, or a combination thereof. In some embodiments, the inorganic material may include, but is not limited to, silicon nitride, silicon oxide, silicon oxynitride, aluminum oxide, other suitable materials, or a combination thereof.

In addition, the subpixel 100 may include a light-emitting unit 200 and a light conversion layer 302 that are disposed between the first substrate 102a and the second substrate 102b, and the light conversion layer 302 may be disposed on the light-emitting unit 200. In accordance with some embodiments, the light-emitting unit 200 may include a light-emitting diode (LED), a micro light-emitting diode, or a mini light-emitting diode, or an organic light-emitting diode (OLED), but the present disclosure is not limited thereto. In some other embodiments, the light-emitting unit 200 may include, but is not limited to, liquid crystals (LC), quantum dots (QD), a fluorescent material, a phosphor material, other suitable materials, or a combination thereof. In some embodiments, the light source provided by the light-emitting unit 200 may include light having short wavelength. For example, the wavelength may be in a range from about 10 nanometers (nm) to about 500 nanometers. In some embodiments, the light source provided by the light-emitting unit 200 may include blue light or UV light.

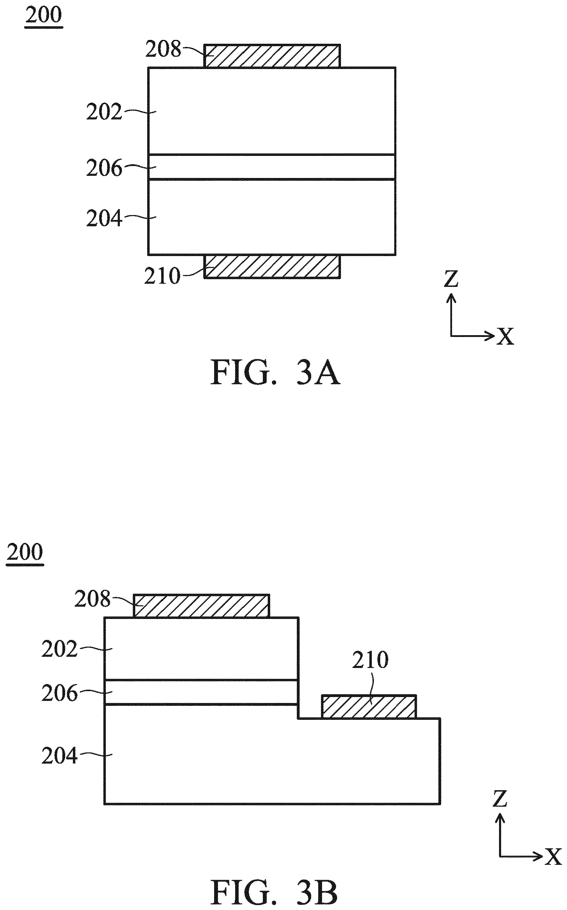

Refer to FIGs. 3A and 3B, which illustrate the cross-sectional diagrams of the light-emitting unit 200 in accordance with some embodiments of the present invention. . As shown in FIG. 3A, in accordance with some embodiments, the light-emitting unit 200 may be a light-emitting unit having a vertical type structure. In accordance with some other embodiments, as shown in FIG. 3B, the light-emitting unit 200 may be a light-emitting unit having a flip-chip type structure.

Specifically, the light-emitting unit 200 may include a first semiconductor layer 202, a second semiconductor layer 204, and an active layer 206. The active layer 206 may be disposed between the first semiconductor layer 202 and the second semiconductor layer 204. In some embodiments, one of the first semiconductor layer 202 and the second semiconductor layer 204 may be used to provide and transport electrons, and the other may be used to provide and transport electron holes. In some embodiments, the first semiconductor layer 202 and the second semiconductor layer 204 may be formed of a semiconductor material having a n-type conductivity and a semiconductor material having a p-type conductivity, respectively. However, in some other embodiments, the first semiconductor layer 202 and the second semiconductor layer 204 may be formed of a semiconductor material having a p-type conductivity and a semiconductor material having a n-type conductivity, respectively.

In some embodiments, the semiconductor material having a n-type conductivity may include, but is not limited to, gallium nitride (n-GaN) or aluminum indium phosphide (n-AlInP), which are doped with tetravalent atoms. In addition, the semiconductor material having a p-type conductivity may include, but is not limited to, gallium nitride (p-GaN) or aluminum indium phosphide (p-AlInP), which are doped with divalent atoms. Moreover, in some embodiments, the active layer 206 may have a quantum well structure. For example, the active layer 206 may include a single quantum well (SQW), a multiple quantum well (MQW), a nanowire, other suitable structures, or a combination thereof. In some embodiments, the material of the active layer 206 may include, but is not limited to, gallium nitride, aluminum indium phosphide (AlInP), indium gallium nitride (InGaN), or a combination thereof.

In some embodiments, the first semiconductor layer 202, the second semiconductor layer 204, and the active layer 206 may be formed by an epitaxial growth process. The epitaxial growth process may include, but is not limited to, a molecular beam epitaxy (MBE) process, a liquid phase epitaxy (LPE) process, a solid phase epitaxy (SPE) process, a vapor phase epitaxy (VPE) process, a selective epitaxial growth (SEG) process, a metal organic chemical vapor deposition (MOCVD) process, an atomic layer deposition (ALD) process or a combination thereof.

In addition, in some embodiments, the light-emitting unit 200 may also include a first electrode layer 208 and a second electrode layer 210 that are disposed on the first semiconductor layer 202 and the second semiconductor layer 204. Specifically, in the embodiments where the light-emitting unit 200 has a vertical type structure, the first electrode layer 208 and the second electrode layer 210 are disposed on opposite sides (as shown in FIG. 3A). In the embodiments where the light-emitting unit 200 has a flip-chip type structure, the first electrode layer 208 and the second electrode layer 210 are disposed on the same side (as shown in FIG. 3B).

In some embodiments, the first electrode layer 208 and the second electrode layer 210 may be further electrically connected to the signal line (not illustrated) and the driving circuit (not illustrated) of the display device 10. In some embodiments, the material of the first electrode layer 208 and the second electrode layer 210 may include a conductive metal material. For example, the conductive metal material may include, but is not limited to, copper (Cu), aluminum (Al), tungsten (W), titanium (Ti), gold (Au), platinum (Pt), nickel (Ni), tin (Sn), indium (In), copper alloy, aluminum alloy, tungsten alloy, titanium alloy, gold alloy, platinum alloy, nickel alloy, tin alloy, indium alloy, other suitable conductive materials, or a combination thereof.

In some embodiments, the first electrode layer 208 and the second electrode layer 210 may be formed by one or more deposition processes, photolithography processes, and etching processes. In some embodiments, the deposition process may include a chemical vapor deposition process, a physical vapor deposition process, an electroplating process, an electroless plating process, other suitable processes, or a combination thereof. In addition, in some embodiments, the photolithography process may include photoresist coating (e.g., spin coating), soft baking, hard baking, mask aligning, exposure, post-exposure baking, developing the photoresist, rinsing, drying, or another suitable process. In some embodiments, the etching process may include a dry etching process, a wet etching process, or another suitable etching process.

It should be understood that, in accordance with some embodiments, the structure of the light-emitting unit 200 may be adjusted or additional elements may be disposed in or on the light-emitting unit 200 according to needs. The light-emitting unit 200 of the present invention is not limited to the structures as described above.

As described above, referring to FIG. 2, the subpixel 100 may include the light conversion layer 302 disposed on the light-emitting unit 200. The light conversion layer 302 may have the function of converting the wavelength of light. For example, the light source generated by the light-emitting unit 200 may be converted into the light having the wavelength of a particular range (the light having a particular color). In some embodiments, the light conversion layer 302 may include a matrix and particles dispersed in the matrix. In some embodiments, the material of the matrix may include, but is not limited to, an organic polymer, an inorganic polymer, glass, or a combination thereof. The matrix may be transparent or semi-transparent in accordance with some embodiments.

In some embodiments, the particles may include, but are not limited to, phosphors, quantum dot (QD) materials, organic fluorescent materials, or a combination thereof. In some embodiments, the light conversion layer 302 may include phosphors that can convert the light source into red light, green light, blue light or light having any other suitable color. In some embodiments, the quantum dot material may have a core-shell structure. The core structure may include, but is not limited to, CdSe, CdTe, CdS, ZnS, ZnSe, ZnO, ZnTe, InAs, InP, GaP, other suitable materials or a combination thereof. The shell structure may include, but is not limited to, ZnS, ZnSe, GaN, GaP, other suitable materials or a combination thereof.

In addition, in some embodiments, the light conversion layer 302 may include scatter particles. For example, the scatter particles may have a high reflection coefficient (e.g., greater than 30%). The scatter particles may further increase light absorption efficiency of the quantum dot material. In some embodiments, the material of the scatter particles may include titanium (Ti) or zinc (Zn). For example, in some embodiments, the scatter particles may include, but are not limited to, titanium dioxide ($TiO_2$), niobium-doped titanium oxide (TNO), zinc oxide (ZnO), zirconium dioxide ($ZrO_2$) or a combination thereof.

In some embodiments, the light conversion layer 302 may be formed by a chemical vapor deposition process, a coating process, a printing process, an inkjet printing process, other suitable processes, or a combination thereof. Moreover, the light conversion layer 302 may be formed by one or more photolithography processes and etching processes.

In addition, in some embodiments, the subpixel 100 may also include an adhesive layer 310 that is disposed between the light-emitting unit 200 and the light conversion layer 302, a first insulating layer 304 that is adjacent to the light-emitting unit 200, and a second insulating layer 306 that is adjacent to the light conversion layer 302. The detailed structures of the adhesive layer 310, the first insulating layer 304 and the second insulating layer 306 will be described in the following context.

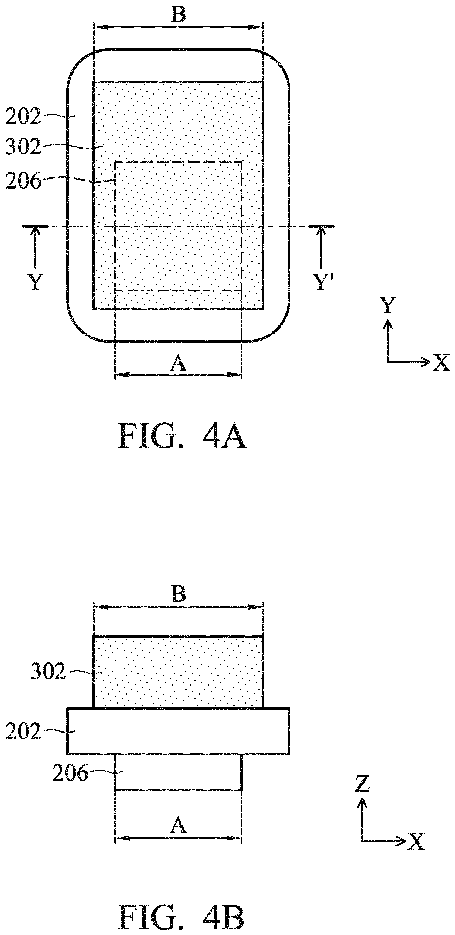

Next, refer to FIGs. 4A and 4B. FIG. 4A illustrates a top-view diagram of the first semiconductor layer 202, the active layer 206 and the light conversion layer 302 in accordance with some examples not forming part of the present invention. . FIG. 4B illustrates a cross-sectional diagram along the line segment Y-Y' in FIG. 4A.

As shown in FIGs. 4A and 4B, in a direction (for example, the X direction) that is perpendicular to the normal direction of the substrate 102a (for example, the Z direction) (illustrated in FIG. 2), the active layer 206 of the light-emitting unit 200 has a first length A and the light conversion layer 302 has a second length B. In accordance with some embodiments, the first length A of the active layer 206 and the second length B of the light conversion layer 302 may conform to the following formula: A+1 micrometers ($\mu$m) <B. In certain embodiments, the first length A may be less than or equal to 200$\mu$m and greater than or equal to 1$\mu$m, but it is not limited thereto. In certain embodiments, the second length B may be less than or equal to 600$\mu$m, but it is not limited thereto.

It should be noted that if the first length A of the active layer 206 is too large (e.g., greater than the second length B), a part of the light of the light-emitting unit 200 may not be converted. In other words, the light conversion layer 302 having the second length B that is greater than the first length A may increase the percentage of light conversion of the light-emitting unit 200. Specifically, in one embodiment, when the second length B (or dimension) of the light conversion layer 302 is about 1.7 times the first length A (or dimension) of the active layer 206, light conversion efficiency can be improved by about 1.5 times. In some embodiments, the ratio (B/A) of the second length B of the light conversion layer 302 to the first length A of the active layer 206 may be in a range from about 1.1 to about 3, for example, 1.2, 1.7 or 2.

In addition, it should be understood that "the first length" and "the second length" as used herein are respectively defined as the length of a short side of a smallest rectangle that can encompass the active layer 206 and the length of a short side of a smallest rectangle that can encompass the light conversion layer 302. More specifically, the smallest rectangles that can encompass the regions of the active layer 206 and the light conversion layer 302 may be defined with a top-view angle of the first substrate 102a or the second substrate 102b. Alternatively, the smallest rectangles that can encompass the regions of the active layer 206 and the light conversion layer 302 may be defined with a plane (for example, the XY plane in the figure) that is substantially perpendicular to the normal direction of the first substrate 102a or the second substrate 102b (for example, the Z direction).

Specifically, in this embodiment, the active layer 206 and the light conversion layer 302 have a rectangular shape, and the first length A of the active layer 206 and the second length B of the light conversion layer 302 are respectively the length of the short side of the active layer 206 and the light conversion layer 302. If the rectangle is a square, either side of the rectangle can be regarded as a short side.

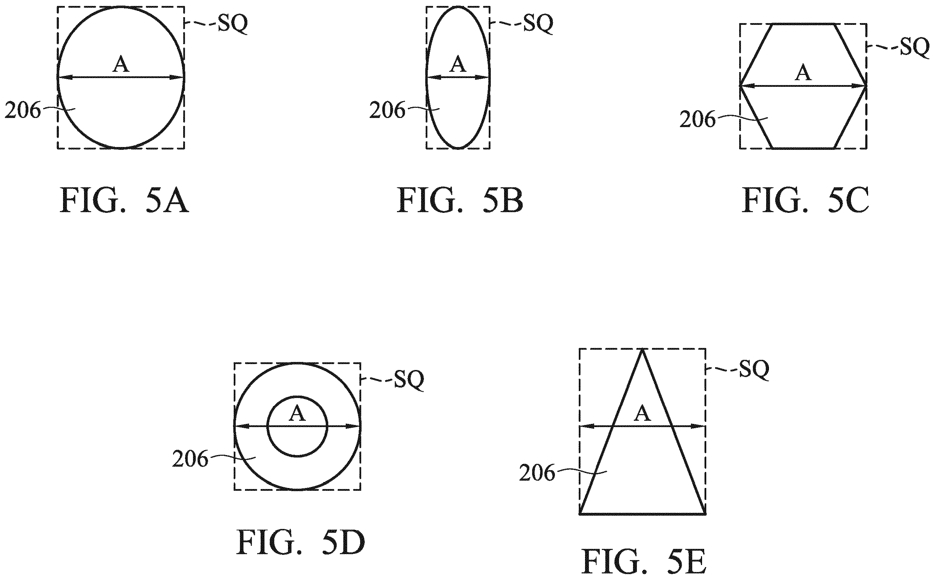

In some other embodiments, the shape of the active layer 206 and the light conversion layer 302 may be non-rectangular. FIGs. 5A-5E illustrate the top-view diagrams of the active layer 206 of the light-emitting unit 200 in accordance with some embodiments of the present invention.

It should be understood that only the active layer 206 are shown in FIGs. 5A-5E to illustrate the definition of the first length A, and the light conversion layer 302 that is not shown in the figure can be defined in the same manner. As shown in FIGs. 5A-5E, in accordance with some embodiments, in a top-view angle of the first substrate 102a or the second substrate 102b, a light-emitting region of the active layer 206 may have a circular shape, an elliptical shape, a hexagonal shape, a ring shape, a triangle shape, an irregular shape, or any other suitable shape. In these embodiments, the first length A of the active layer 206 is the length of the short side of the smallest rectangle SQ that can encompass the active layer 206.

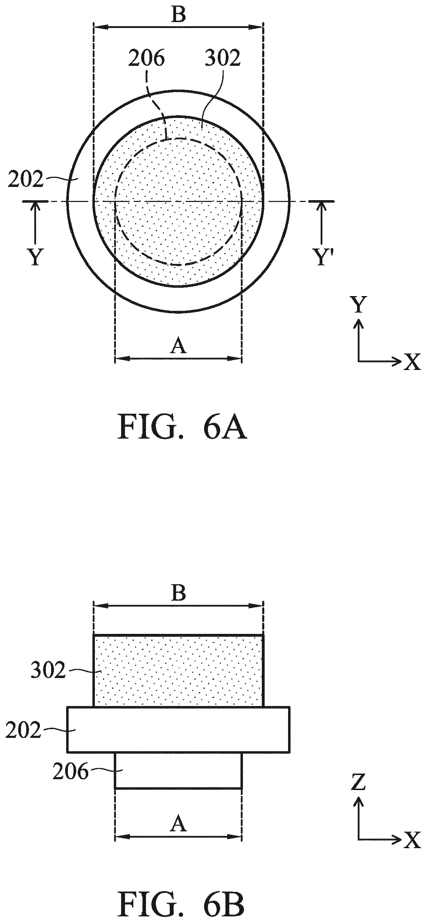

Refer to FIGs. 6A and 6B. FIG. 6A illustrates a top-view diagram of the first semiconductor layer 202, the active layer 206 and the light conversion layer 302 in accordance with some other examples not forming part of the present invention. . FIG. 6B illustrates a cross-sectional diagram along the line segment Y-Y' in FIG. 6A. As shown in FIGs. 6A and 6B, in some embodiments, the light-emitting regions of the active layer 206 and the light conversion layer 302 may both have a circular shape. In this embodiment, the first length A of the active layer 206 and the second length B of the light conversion layer 302 also conform to the following formula: $A+1\mu m<B$.

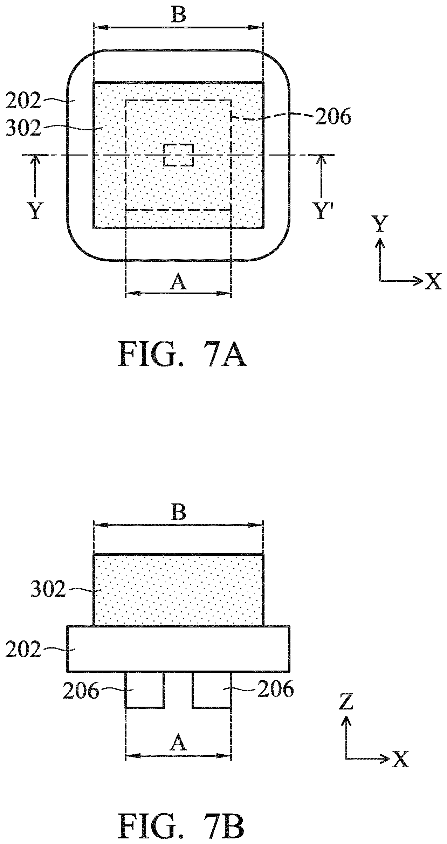

It should be understood that although the light-emitting region of the active layer 206 have the same or similar shape as the light conversion layer 302 in the embodiments as described above, the light-emitting region of the active layer 206 may have a different shape from the light conversion layer 302 in accordance with some other embodiments. For example, refer to FIGs. 7A and 7B. FIG. 7A illustrates a top-view diagram of the light-emitting unit 200 and the light conversion layer 302 in accordance with some other examples not forming part of the present invention. . FIG. 7B illustrates a cross-sectional diagram along the line segment Y-Y' in FIG. 7A. In this embodiment, the shape of the light-emitting region of the active layer 206 may be a rectangle having a hollowed-out region, and the shape of the light conversion layer 302 may be a rectangle. In this embodiment, the first length A of the active layer 206 and the second length B of the light conversion layer 302 also conform to the following formula: $A+1\mu m<B$.

Furthermore, in accordance with some embodiments, the second length B of the light conversion layer 302 and the pitch $S_p$ by which the subpixels 100 are spaced apart conform to the following formula: $B<S_p-1\mu m$. In certain embodiments, the pitch $S_p$ may be less than or equal to $300\mu m$, but the present disclosure is not limited thereto.

It should be noted that if the pitch $S_p$ is too small (for example, less than the second length B), the subpixel 100 may be disturbed by a crosstalk effect, which may result in color mixing of the light sources. Therefore, the purity of the color of light source of the light-emitting unit 200 may be reduced.

Furthermore, in accordance with some embodiments, the first length A of the active layer 206 and the second length B of the light conversion layer 302 conform to the following formula: $A+1\mu m<B<S_p-1\mu m$.

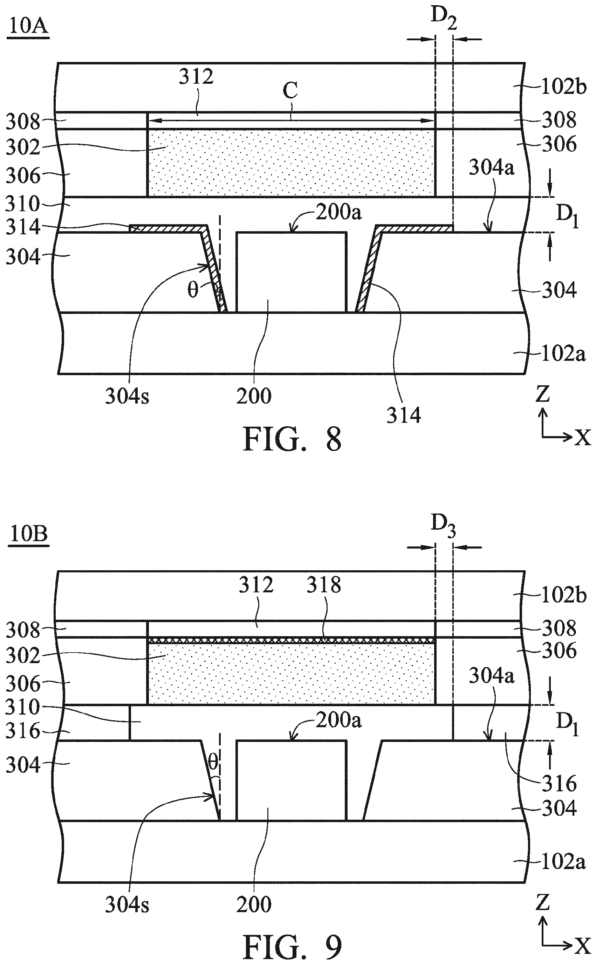

Next, refer to FIG. 8, which illustrates a cross-sectional diagram of a display device 10A in accordance with some examples not forming part of the present invention. . It should be understood that the same or similar components or elements in above and below contexts are represented by the same or similar reference numerals. The materials, manufacturing methods and functions of these components or elements are the same or similar to those described above, and thus will not be repeated herein.

As shown in FIG. 8, the display device 10A may include the first substrate 102a, the second substrate 102b, the light-emitting unit 200 and the light conversion layer 302. The second substrate 102b may be disposed opposite to the first substrate 102a. The light-emitting unit 200 and the light conversion layer 302 may be disposed between the first substrate 102a and the second substrate 102b.

In addition, in some embodiments, the display device 10A may further include the first insulating layer 304 and the second insulating layer 306. The first insulating layer 304 and the second insulating layer 306 may be disposed between the first substrate 102a and the second substrate 102b. In some embodiments, the first insulating layer 304 may be disposed on the first substrate 102a and adjacent to the light-emitting unit 200, and the second insulating layer 306 may be disposed on the first insulating layer 304 and adjacent to the light conversion layer 302. The first insulating layer 304 and the second insulating layer 306 may serve as light shielding layers to reduce crosstalk effects or enhance the color gamut range. In some embodiments, light conversion layer 302 may substantially define an area of the subpixel of the display device 10A.

As shown in FIG. 8, in some embodiments, the first insulating layer 304 and the second insulating layer 306 may be spaced apart by a distance $D_1$. The distance $D_1$ may be the minimum distance between the first insulating layer 304 and the second insulating layer 306 along the normal direction of the first substrate 102a (for example, the Z direction) in a cross section. In some other embodiments, the light-emitting unit 200 and the light conversion layer 302 also may be spaced apart by the distance $D_1$. In some embodiments, the distance $D_1$ may be greater than or equal to $0.1\mu m$ and less than or equal to $10\mu m$, for example, $2\mu m$, $5\mu m$, or $7\mu m$.

It should be noted that if the distance $D_1$ is too small (for example, less than $0.1\mu m$), the adhesive layer 310 disposed between the first insulating layer 304 and the second insulating layer 306 may not be able to efficiently fix the structure. Conversely, if the distance $D_1$ is too large (for example, greater than $10\mu m$), light conversion efficiency of the light-emitting unit 200 may be decreased. Specifically, for the above embodiments in which the second length B of the light conversion layer 302 is about 1.7 times the first length A of the active layer 206, when the distance $D_1$ is decreased from $3\mu m$ to $1\mu m$, light conversion efficiency can be increased by about 1.2 times.

Furthermore, in some embodiments, the first insulating layer 304 may be not in contact with the light-emitting unit 200. In some other embodiments, the first insulating layer 304 may be in contact with the light-emitting unit 200, for example, a sidewall 304s of the first insulating layer 304 may be in contact with the light-emitting unit 200. In some embodiments, the sidewall 304s of the first insulating layer 304 that is adjacent to the light-emitting unit 200 and the normal direction of the first substrate 102a (e.g., the Z direction) may include an included angle θ therebetween. For example, the included angle θ may be in a range from about 0 degree to about 45 degrees, such as about 15 degrees, about 30 degrees, or about 40 degrees.

In some embodiments, the first insulating layer 304 and the second insulating layer 306 may include an insulating material. In some embodiments, the first insulating layer 304 and/or the second insulating layer 306 may include a material having a light shielding property. For example, the first insulating layer 304 and the second insulating layer 306 may include a material having high reflectivity (e.g., greater than 30%) or low reflectivity (e.g., less than 30%). In some embodiments, the material of the first insulating layer 304 and/or the second insulating layer 306 may include a black photoresist or a white photoresist. In some embodiments, the materials of the first insulating layer 304 and the second insulating layer 306 may include, but is not limited to, an organic resin, a glass paste, other suitable materials, or a combination thereof.

In some embodiments, the materials of the first insulating layer 304 and the second insulating layer 306 may further include a reflective material. For example, in some embodiments, the first insulating layer 304 and the second insulating layer 306 may further include metal particles (e.g., nickel, aluminum, molybdenum, and alloys thereof), metal oxide particles (e.g., chromium oxide or titanium dioxide), metal nitride particles (e.g., chromium nitride), graphite particles, or a combination thereof, but they are not limited thereto. In addition, the first insulating layer 304 and the second insulating layer 306 may be formed of the same material or different materials. In some embodiments, the material of the first insulating layer 304 may include black photoresists, and the material of the second insulating layer 306 may include white photoresists.

In some embodiments, the first insulating layer 304 and the second insulating layer 306 may be formed by a chemical vapor deposition process, a coating process, a printing process, an inkjet printing process, other suitable processes, or a combination thereof. Furthermore, the first insulating layer 304 and the second insulating layer 306 may be formed by one or more photolithography processes and etching processes.

Moreover, in some embodiments, the display device 10A may further include a third insulating layer 308 disposed between the second insulating layer 306 and the second substrate 102b. The material of the third insulating layer 308 may be similar to the materials of the first insulating layer 304 and second insulating layer 306 as described above. In some embodiments where the material of the second insulating layer 306 includes white photoresists, the material of the third insulating layer 308 may include black photoresists.

In addition, in some embodiments, the display device 10A may further include the adhesive layer 310 disposed between the first insulating layer 304 and the second insulating layer 306. In some embodiments, the adhesive layer 310 may be in contact with the light conversion layer 302, the first insulating layer 304, and the second insulating layer 306, and the second substrate 102b may be fixed on the first substrate 102a. As shown in FIG. 8, in some embodiments, the adhesive layer 310 may be disposed between the first insulating layer 304 and the light-emitting unit 200. In some other embodiments, the light-emitting unit 200 may be partially disposed in the first insulating layer 304 with only a top surface 200a in contact with the adhesive layer 310, but it is not limited thereto. Alternatively, in some other embodiments, the light-emitting unit 200 may be entirely disposed in the first insulating layer 304 without being in contact with the adhesive layer 310.

The adhesive layer 310 may include an adhesive material. In some embodiments, the adhesive layer 310 may include, but is not limited to, an optical clear adhesive (OCA), an optical clear resin (OCR), other suitable adhesive materials, or a combination of the thereof. In some embodiments, the adhesive layer 310 may be transparent or semi-transparent.

In some embodiments, the adhesive layer 310 may be formed by a chemical vapor deposition process, a coating process, a printing process, an inkjet printing process, other suitable processes, or a combination thereof.

Furthermore, in some embodiments, the display device 10A may further include a filter layer 312 disposed on the light conversion layer 302. The filter layer 312 may filter or adjust the optical properties of the light that passes through the light conversion layer 302. In some embodiments, the filter layer 312 may include, but is not limited to, a red-light filter layer, a greenlight filter layer, a blue-light filter layer, other filter layers having suitable colors or performances, or a combination thereof. In some embodiments, the filter layer 312 and the light conversion layer 302 may have substantially the same or similar dimensions, that is, in a cross section, in a direction (for example, the X direction) that is perpendicular to the normal direction of the first substrate 102a (for example, the Z direction), a third length C of the filter layer 312 and the first length A of the active layer 206 may conform to the following formula: $A+1\mu m<C<S_p-1\mu m$. In some other embodiments, the third length C of the filter layer 312 may be greater than or equal to the second length B of the light conversion layer 302.

In addition, in some embodiments, the display device 10A may further include a first reflective layer 314 disposed on a portion of the first insulating layer 304. As shown in FIG. 8, in some embodiments, a portion of the first reflective layer 314 may be disposed between the light-emitting unit 200 and the first insulating layer 304, a portion of the first reflective layer 314 may be disposed between the light conversion layer 302 and the first insulating layer 304, and a portion of the first insulating layer 304 may be disposed between the second insulating layer 306 and the first insulating layer 304. The first reflective layer 314 may reflect the light emitted by the light-emitting unit 200 to the light conversion layer 302 to increase light conversion efficiency of the light-emitting unit 200.

As described above, a portion of the first reflective layer 314 may be disposed between the second insulating layer 306 and the first insulating layer 304. That is, the first reflective layer 314 and the second insulating layer 306 may at least partially overlap. Specifically, the first reflective layer 314 and the second insulating layer 306 may at least partially overlap in the normal direction of the first substrate 102a or the second substrate 102b. In some embodiments, in a cross section, the first reflective layer 314 and the second insulating layer 306 may overlap each other with a distance $D_2$ in a range of at least $1\mu m$ (greater than or equal to $1\mu m$), for example, $2\mu m$ to $100\mu m$, or $10\mu m$ to $50\mu m$, but the present disclosure is not limited thereto. It should be understood that if the distance $D_2$ is too large, for example, greater than a half of the pitch ($S_P/2$), the light reflected by the first reflective layer 314 may affect other adjacent subpixels, which may result in the mixing of light.

The first reflective layer 314 may include a material having reflective properties. In some embodiments, the material of the first reflective layer 314 may include a metal. For example, the metal may include, but is not limited to, copper (Cu), aluminum (Al), indium (In), ruthenium (Ru), tin (Sn), gold (Au), platinum (Pt), zinc (Zn), silver (Ag), titanium (Ti), lead (Pb), nickel (Ni), chromium (Cr), magnesium (Mg), palladium (Pd), copper alloy, aluminum alloy, indium alloy, ruthenium alloy, tin alloy, gold alloy, platinum alloy, zinc alloy, silver alloy, titanium alloy, lead alloy, nickel alloy, chromium alloy, magnesium alloy, palladium alloy, other suitable materials or a combination thereof. In some other embodiments, the material of the first reflective layer 314 may further include titanium dioxide, silicon dioxide or a combination thereof.

In some embodiments, the first reflective layer 314 may be formed by the above deposition process, coating process, printing process, inkjet printing process, other suitable processes, or a combination thereof. Furthermore, the first reflective layer 314 may be formed by one or more photolithography processes and etching processes.

Next, refer to FIG. 9, which illustrates a cross-sectional diagram of a display device 10B in accordance with some other examples not forming part of the present invention. . The display device 10B is substantially similar to the display device 10A shown in FIG. 8. The difference between them is that, the display device 10B may further include a first spacer layer 316 disposed between the first insulating layer 304 and the second insulating layer 306 in the embodiment shown in FIG. 9. In some embodiments, the display device 10B may further include a second spacer layer 318 disposed between the light conversion layer 302 and the filter layer 312. In some embodiments, the material of the second spacer layer 318 may include, but is not limited to, material having a low refraction coefficient, and the refraction coefficient may, for example, be between 1 and 1.5, but the present disclosure is not limited thereto.

The first spacer layer 316 may include a material having low reflectivity (e.g., less than 30%) or low light transmittance (e.g., less than 10%). In some embodiments, the material of the first spacer layer 316 may include black photoresists. In some embodiments, the first spacer layer 316 may include, but is not limited to, an organic resin, a glass paste, other suitable materials, or a combination thereof. In some embodiments, the first spacer layer 316 may further include, but is not limited to, metal oxide particles (e.g., chromium oxide or titanium dioxide), metal nitride particles (e.g.,

chromium nitride), graphite particles, or a combination thereof.

Specifically, in this embodiment, the material of the first insulating layer 304 may be formed of a material having high reflectivity (for example, greater than 30%). For example, a material having high reflectivity may include white photoresists. As described above, the first spacer layer 316 may be formed of a material having low light transmittance, and therefore, the influence of the light reflected by the first insulating layer 304 on adjacent subpixels may be reduced, or mutual interference between the subpixels may be reduced. Furthermore, in this embodiment, since the first insulating layer 304 may be formed of a material having high reflectivity, the first reflective layer 314 may not be additionally disposed on the first insulating layer 304. In some other embodiments, the first insulating layer 304 may be in contact with the light-emitting unit 200.

In some embodiments, in a cross section, in a direction perpendicular to the normal direction of the first substrate 102a or the second substrate 102b, the first spacer layer 316 and the light conversion layer 302 may be spaced apart by a minimum distance $D_3$. In some embodiments, the range of the distance $D_3$ may be greater than or equal to 1$\mu$m, for example, from about 1$\mu$m to about 200$\mu$m, or from about 50$\mu$m to about 100$\mu$m, but the present disclosure is not limited thereto.

Furthermore, the second spacer layer 318 may be formed of a material having a low refraction coefficient, for example, the refractive coefficient may be less than 1.5. In some embodiments, the material of the second spacer layer 318 may include, but is not limited to, an organic resin, a glass paste, a siloxane polymer, other suitable materials, or a combination thereof. In some embodiments, the material of the second spacer layer 318 may further include a silicon oxide compound, a resin, an air gap, or a combination thereof. For example, the second spacer layer 318 may include the silicon oxide compound and the air gap. The second spacer layer 318 may also include the resin and the air gap. In some embodiments, the second spacer layer 318 may be transparent or semi-transparent.

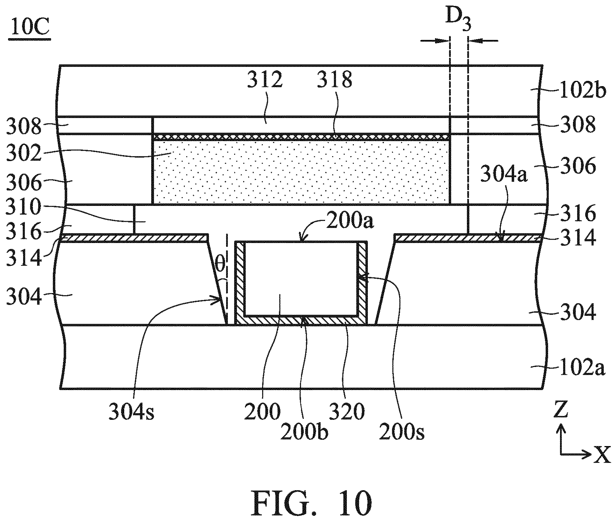

Next, refer to FIG. 10, which illustrates a cross-sectional diagram of a display device 10C in accordance with some embodiments of the present invention. The display device 10C is substantially similar to the display device 10B shown in FIG. 9. The difference between them is that, the display device 10C may further include a second reflective layer 320 disposed on a sidewall 200s of the light-emitting unit 200 in the embodiment shown in FIG. 10. In some embodiments, the second reflective layer 320 may also be disposed on a bottom surface 200b of the light-emitting unit 200. In some embodiments, the second reflective layer 320 may be in contact with the sidewall 200s and the bottom surface 200b of the light-emitting unit 200. In addition, the second reflective layer 320 may expose the contact structure (e.g., the first electrode layer 208 and the second electrode layer 210) of the light-emitting unit 200 for electrical connection.

The second reflective layer 320 may reduce the light emitted by the light-emitting unit 200 from being absorbed by the first insulating layer 304, and thereby the light-emitting efficiency of the light-emitting unit 200 may be improved. In some embodiments, the second reflective layer 320 may include an omni-directional reflector (ODR) structure, a distributed Bragg reflector (DBR) structure, or a combination thereof. In particular, the omni-directional reflector structure may include a stack of dielectric material/metal reflective material/dielectric material, and the Bragg reflector structure may include a stack of a plurality of dielectric materials having different refraction coefficients. In some embodiments, the dielectric material may include, but is not limited to, silicon oxide ($SiO_x$), silicon nitride (SiNx), silicon oxynitride (SiON), aluminum oxide ($Al_2O_3$), titanium dioxide ($TiO_2$), other suitable materials, or combination thereof. In some embodiments, the metal reflective material may include, but is not limited to, copper, aluminum, indium, ruthenium, tin, gold, platinum, zinc, silver, titanium, lead, nickel, chromium, magnesium, palladium, copper alloy, aluminum alloy, indium alloy, ruthenium alloy, tin alloy, gold alloy, platinum alloy, zinc alloy, silver alloy, titanium alloy, lead alloy, nickel alloy, chromium alloy, magnesium alloy, palladium alloy, other suitable materials or a combination thereof.

In some embodiments, the second reflective layer 320 may be formed by the above deposition process, coating process, printing process, inkjet printing process, other suitable processes, or a combination thereof. Furthermore, the second reflective layer 320 may be formed by one or more photolithography processes and etching processes.

In addition, in this embodiment, at least a portion of the first reflective layer 314 is disposed on a top surface 304a of the first insulating layer 304 and extend between the first spacer layer 316 and the first insulating layer 304. In this embodiment, since the second reflective layer 320 is disposed on the light-emitting unit 200, the first reflective layer 314 that is disposed on the sidewall 304s of the first insulating layer 304 may be optionally omitted. Moreover, in this embodiment, the material of the first insulating layer 304 may include a material having low light transmittance, for example, may include black photoresists, but it is not limited thereto.

To summarize the above, in accordance with the present invention, the subpixel of the display device includes the active layer and the light conversion layer having a specific dimensional relationship. In addition, in accordance with some embodiments of the present invention, the distance between the light-emitting unit and the light conversion layer may be in a specific range. With the specific configuration of the subpixel structure as described above, light conversion efficiency of the display device may be improved, or crosstalk between subpixels may be reduced.

Although some embodiments of the present invention and their advantages have been described in detail, it should be understood that various changes, substitutions and alterations can be made herein without departing from the scope of the present invention as defined by the appended claims. For example, it will be readily understood by one of ordinary skill in the art that many of the features, functions, processes, and materials described herein may be varied while remaining within the scope of the present invention. Moreover, the scope of the present invention is not intended to be limited to the particular embodiments of the process, machine, manufacture, composition of matter, means, methods and steps described above.

**Claims**

1. A display device (10), comprising:

   a first substrate (102a);
   a first subpixel (100a) disposed on the first substrate; and
   a second subpixel (100b) disposed adjacent to the first subpixel and spaced apart from each other by a pitch ($S_p$), and at least one of the first subpixel and the second subpixel comprises:
   a light-emitting unit (200) comprising an active layer, the active layer having a first length (A)
   along a direction that is perpendicular to a normal direction of the first substrate;
   a light conversion layer (302) disposed on the light-emitting unit, the light conversion layer having a second length (B)
   along the direction that is perpendicular to the normal direction of the first substrate;
   a first insulating layer (304) disposed adjacent to the light-emitting unit;
   a second insulating layer (306) disposed on the first insulating layer adjacent to the light conversion layer,
   a first reflective layer (314) disposed on a portion of the first insulating layer; and
   a first spacer layer (316) disposed between the first insulating layer and the second insulating layer;
   wherein the first length, the second length and the pitch conform to the following formula:
   A+1 micrometers < B < $S_p$-1 micrometers, and wherein the first reflective layer is disposed on a top surface of the first insulating layer and extends between the first spacer layer and the first insulating layer (304).

2. The display device as claimed in claim 1, wherein a distance ($D_1$) between the first insulating layer and the second insulating layer is greater than or equal to 0.1 micrometers and less than or equal to 10 micrometers.

3. The display device as claimed in claim 1, further comprising an adhesive layer (310) disposed between the first insulating layer and the second insulating layer.

4. The display device as claimed in claim 1, wherein at least a portion of the first reflective layer is disposed between the first insulating layer and the second insulating layer.

5. The display device as claimed in claim 4, wherein the first reflective layer and the second insulating layer at least partially overlap each other.

6. The display device as claimed in claim 5, wherein the first reflective layer and the

   second insulating layer overlap each other with a distance ($D_2$) greater than or
   equal to 1 micrometer.

7. The display device as claimed in claim 1, wherein the first spacer layer and the light conversion layer are spaced apart by a distance ($D_3$) greater than or equal to 1 micrometer.

8. The display device as claimed in any of the claims 2 to 7, wherein a material of the first insulating layer comprises a reflective material.

9. The display device as claimed in any of the claims 1 to 8, further comprising a filter layer (312) disposed on the light conversion layer; and a second spacer layer (318) disposed between the light conversion layer and the filter layer.

10. The display device as claimed in claim 9, wherein the filter layer has a third length along the direction that is perpendicular to the normal direction of the first substrate, and the third length, the first length and the pitch conform to the following formula: A+1 micrometers < C < $S_p$-1 micrometers.

11. The display device as claimed in any of the claims 1 to 10, further comprising a second reflective layer (320) disposed on a sidewall of the light-emitting unit and wherein the second reflective layer is further disposed on a bottom surface of the light-emitting unit.

12. The display device as claimed in claim 11, wherein the second reflective layer comprises an omni-directional reflector (ODR) structure, a distributed Bragg reflector (DBR) structure, or a combination thereof.

13. The display device as claimed in any of the claims 1 to 12, wherein a ratio of the second length of the light conversion layer to the first length of the active layer is in a range from 1.1 to 3.

**Patentansprüche**

1. Eine Anzeigevorrichtung (10), die Folgendes umfasst:

ein erstes Substrat (102a);
ein erstes Subpixel (100a), das auf dem ersten Substrat angeordnet ist; und
ein zweites Subpixel (100b), das benachbart zu dem ersten Subpixel angeordnet und durch einen Abstand ($S_p$) voneinander beabstandet ist, und wobei mindestens eines von dem ersten Subpixel und dem zweiten Subpixel umfasst:
eine lichtemittierende Einheit (200), die eine aktive Schicht umfasst, wobei die aktive Schicht eine erste Länge (A) entlang einer Richtung aufweist, die senkrecht zu einer normalen Richtung des ersten Substrats ist;
eine Lichtumwandlungsschicht (302), die auf der lichtemittierenden Einheit angeordnet ist, wobei die Lichtumwandlungsschicht eine zweite Länge (B) entlang der Richtung hat, die senkrecht zu der normalen Richtung des ersten Substrats ist;
eine erste Isolierschicht (304), die angrenzend an die lichtemittierende Einheit angeordnet ist;
eine zweite Isolierschicht (306), die auf der ersten Isolierschicht angrenzend an die Lichtumwandlungsschicht angeordnet ist;
eine erste reflektierende Schicht (314), die auf einem Teil der ersten Isolierschicht angeordnet ist; und
eine erste Abstandshalterschicht (316), die zwischen der ersten Isolierschicht und der zweiten Isolierschicht angeordnet ist;
wobei die erste Länge, die zweite Länge und der Abstand der folgenden Formel entsprechen: A+1 Mikrometer < B < $S_p$ -1 Mikrometer, und
wobei die erste reflektierende Schicht auf einer oberen Oberfläche der ersten Isolierschicht angeordnet ist und sich zwischen der ersten Abstandsschicht und der ersten Isolierschicht (304) erstreckt.

2. Die Anzeigevorrichtung nach Anspruch 1,
wobei ein Abstand ($D_1$) zwischen der ersten Isolierschicht und der zweiten Isolierschicht größer als oder gleich 0,1 Mikrometer und kleiner als oder gleich 10 Mikrometer ist.

3. Die Anzeigevorrichtung nach Anspruch 1, die ferner eine Klebeschicht (310) umfasst, die zwischen der ersten Isolierschicht und der zweiten Isolierschicht angeordnet ist.

4. Die Anzeigevorrichtung nach Anspruch 1, wobei mindestens ein Teil der ersten reflektierenden Schicht zwischen der ersten Isolierschicht und der zweiten Isolierschicht angeordnet ist.

5. Die Anzeigevorrichtung nach Anspruch 4, wobei die erste reflektierende Schicht und die zweite Isolierschicht einander zumindest teilweise überlappen.

6. Die Anzeigevorrichtung nach Anspruch 5, wobei die erste reflektierende Schicht und die zweite Isolierschicht einander mit einem Abstand ($D_2$) überlappen, der größer als oder gleich 1 Mikrometer ist.

7. Die Anzeigevorrichtung nach Anspruch 1, wobei die erste Abstandsschicht und die Lichtumwandlungsschicht um einen Abstand ($D_3$) größer als oder gleich 1 Mikrometer voneinander beabstandet sind.

8. Die Anzeigevorrichtung nach einem der Ansprüche 2 bis 7, wobei ein Material der ersten Isolierschicht ein reflektierendes Material umfasst.

9. Die Anzeigevorrichtung nach einem der Ansprüche 1 bis 8, ferner umfassend eine Filterschicht (312), die auf der Lichtumwandlungsschicht angeordnet ist, und eine zweite Abstandsschicht (318), die zwischen der Lichtumwandlungsschicht und der Filterschicht angeordnet ist.

**10.** Die Anzeigevorrichtung nach Anspruch 9, wobei die Filterschicht eine dritte Länge entlang der Richtung hat, die senkrecht zu der normalen Richtung des ersten Substrats ist, und die dritte Länge, die erste Länge und der Abstand der folgenden Formel entsprechen:

A+1 Mikrometer < C < $S_p$ -1 Mikrometer.

**11.** Die Anzeigevorrichtung nach einem der Ansprüche 1 bis 10, ferner mit einer zweiten reflektierenden Schicht (320), die auf einer Seitenwand der lichtemittierenden Einheit angeordnet ist, und wobei die zweite reflektierende Schicht ferner auf einer Bodenfläche der lichtemittierenden Einheit angeordnet ist.

**12.** Die Anzeigevorrichtung nach Anspruch 11, wobei die zweite Reflexionsschicht eine omnidirektionale Reflektorstruktur (ODR), eine verteilte Bragg-Reflektorstruktur (DBR) oder eine Kombination davon umfasst.

**13.** Die Anzeigevorrichtung nach einem der Ansprüche 1 bis 12, wobei das Verhältnis zwischen der zweiten Länge der Lichtumwandlungsschicht und der ersten Länge der aktiven Schicht im Bereich von 1,1 bis 3 liegt.

**Revendications**

**1.** Un dispositif d'affichage (10), comprenant :

un premier substrat (102a) ;
un premier sous-pixel (100a) disposé sur le premier substrat ; et
un deuxième sous-pixel (100b) disposé de manière adjacente par rapport au premier sous-pixel et espacés l'un de l'autre d'un pas ($S_p$), et au moins l'un parmi le premier sous-pixel et le deuxième sous-pixel comprend :

une unité électroluminescente (200) comprenant une couche active, la couche active ayant une première longueur (A) le long d'une direction qui est perpendiculaire à une direction normale du premier substrat ; et
une couche de conversion de lumière (302) disposée sur l'unité électroluminescente, la couche de conversion de lumière ayant une seconde longueur (B) le long de la direction qui est perpendiculaire à la direction normale du premier substrat ;
une première couche isolante (304) disposée adjacente à l'unité électroluminescente;
une seconde couche isolante (306) disposée sur la première couche isolante adjacente à la couche de conversion de lumière,
une première couche réfléchissante (314) disposée sur une partie de la première couche isolante ; et
une première couche d'espacement (316) disposée entre la première couche isolante et la seconde couche isolante.
dans lequel la première longueur, la seconde longueur et le pas se conforment à la formule suivante :

$$1+1 \text{ micromètres} < B < S_p - 1 \text{ micromètres,}$$

et

Dans lequel la première couche réfléchissante est disposée sur une surface supérieure de la première couche isolante et s'étend entre la première couche d'espacement et la première couche isolante (304).

**2.** Le dispositif d'affichage tel que revendiqué dans la revendication 1 dans lequel une distance (D1) entre la première couche isolante et la deuxième couche isolante est supérieure ou égale à 0,1 micromètre et inférieure ou égale à 10 micromètres.

**3.** Le dispositif d'affichage tel que revendiqué dans la revendication 1 , comprenant en outre une couche adhésive (310) disposée entre la première couche isolante et la deuxième couche isolante.

**4.** Le dispositif d'affichage tel que revendiqué dans la revendication 1, dans lequel au moins une partie de la première couche réfléchissante est disposée entre la première couche isolante et la seconde couche isolante.

**5.** Le dispositif d'affichage tel que revendiqué dans la revendication 4, dans lequel la première couche réfléchissante et la deuxième couche isolante se chevauchent au moins partiellement.

**6.** Le dispositif d'affichage tel que revendiqué dans la revendication 4, dans lequel la première couche réfléchissante et la deuxième couche isolante se chevauchent avec une distance ($D_2$) supérieure ou égale à 1 micromètre.

**7.** Le dispositif d'affichage tel que revendiqué dans la revendication 1, dans lequel la première couche d'espacement et la couche de conversion de lumière sont espacée d'une distance (D3) supérieure ou égale à 1 micromètre.

**8.** Le dispositif d'affichage tel que revendiqué dans l'une quelconque des revendications 2 à 8, dans lequel un matériau de la première couche isolante comprend un matériau réfléchissant.

**9.** Le dispositif d'affichage tel que revendiqué dans l'une quelconque des revendications 1 à 8, comprenant en outre une couche de filtre (312) disposée sur la couche de conversion de lumière ; et une seconde couche d'espacement (318) disposée entre la couche de conversion de lumière et la couche de filtre.

**10.** Le dispositif d'affichage tel que revendiqué dans la revendication 9, dans lequel la couche de filtre a une troisième longueur le long de la direction qui est perpendiculaire à la direction normale du premier substrat, et la troisième longueur, la première longueur et le pas répondent à la formule suivante :
A + 1 micromètres < C < $S_p$ - 1 micromètres .

**11.** Le dispositif d'affichage tel que revendiqué dans l'une quelconque des revendications 1 à 10, comprenant en outre une seconde couche réfléchissante (320) disposée sur une paroi latérale de l'unité électroluminescente et dans lequel la seconde couche réfléchissante est en outre disposée sur une surface inférieure de l'unité électroluminescente.

**12.** Le dispositif d'affichage tel que revendiqué dans la revendication 11, dans lequel la seconde couche réfléchissante comprend une structure de réflecteur omnidirectionnel (ODR), une structure de réflecteur de Bragg distribué (DBR) ou une combinaison de celles-ci.

**13.** Le dispositif d'affichage tel que revendiqué dans l'une quelconque des revendications 1 à 12, dans lequel un rapport de la deuxième longueur de la couche de conversion de lumière à la première longueur de la couche active est dans une plage comprise entre 1,1 et 3.

FIG. 1

EP 3 621 109 B1

100

FIG. 2

200

208

202

206

204

210

Z

X

FIG. 3A

200

208

202

206

210

204

Z

X

FIG. 3B

FIG. 4A

FIG. 4B

FIG. 5A

FIG. 5B

FIG. 5C

FIG. 5D

FIG. 5E

EP 3 621 109 B1

B

206    302

202

Y    Y'

A

Y

→X

FIG. 6A

B

302

202

206

A

Z

→X

FIG. 6B

FIG. 7A

FIG. 7B

FIG. 8

FIG. 9

FIG. 10

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2018151543 A1
- US 2015255505 A1
- US 2018182931 A1